# FASCICULE DE BREVET EUROPEEN

(11) **EP 0 703 599 B1**
(45) Date de publication et mention de la délivrance du brevet: **03.12.1997**
(21) Numéro de dépôt: 95402127.5
(22) Date de dépôt: 21.09.1995
(51) Int. Cl.: H01J 37/34

(54) **Cathode rotative de pulvérisation cathodique à plusieurs cibles**
Kathodenzerstäubungs-Drehkathode mit mehreren Targets
Rotating cathodic sputtering cathode with plural targets

(30) Priorité: 22.09.1994 FR 9411319
(43) Date de publication de la demande: 27.03.1996
(73) Titulaire: SAINT-GOBAIN VITRAGE, 92400 Courbevoie (FR)
(72) Inventeur: Dresse, Louis, B-5000 Beez (BE)
(74) Mandataire: Muller, René

(56) Documents cités:
- EP-A- 0 461 035
- EP-A- 0 537 011
- PATENT ABSTRACTS OF JAPAN vol. 018 no. 040 (C-1155) ,21 Janvier 1994 & JP-A-05 263225 (ASAHI GLASS CO LTD) 12 Octobre 1993
- PATENT ABSTRACTS OF JAPAN vol. 006 no. 250 (C-139) ,9 Décembre 1982 & JP-A-57 145983 (MURATA SEISAKUSHO:KK) 9 Septembre 1982
- PATENT ABSTRACTS OF JAPAN vol. 013 no. 079 (C-571) ,22 Février 1989 & JP-A-63 266062 (SUMITOMO METAL MINING CO LTD) 2 Novembre 1988

## Description

L'invention concerne la pulvérisation cathodique à magnétrons et plus particulièrement une cathode rotative pour la pulvérisation cathodique selon la première partie de la revendication 1, dans laquelle les cibles pulvérisées sont de forme cylindrique et tournent autour de l'axe du cylindre.

Les cathodes de pulvérisation du type précédent ont été développées essentiellement pour remplir deux fonctions, d'une part limiter l'échauffement du matériau de la cible, ce qui permet d'accroître la vitesse de dépôt et d'autre part, permettre le dépôt réactif de matériaux dont la réaction avec le gaz produit un composé isolant qui peut se dépose sur la cible elle-même, qui, en l'absence de cathode rotative, ne peut plus jouer son rôle de cathode et qui cesse alors d'attirer les ions lourds. Une conséquence indirecte de l'utilisation de cibles tournante est l'obtention d'une usure régulière du matériau de la cible, ce qui n'est pas possible avec les magnétrons de type « planar ».

Un des problèmes rencontrés sur les installations industrielles et davantage encore, sur les installations utilisées en recherche et développement est celui du changement rapide des cibles. Lorsqu'on dépose sur un substrat des multicouches à base de métaux ou de composés métalliques différents, il est important de pouvoir remplacer rapidement le matériau de cible par un autre.

Il existe des systèmes de cathodes à magnétrons « planar » qui sont équipés de cibles qui permettent le remplacement rapide d'une plaque d'un métal par une plaque d'un métal différent. Ces systèmes cependant nécessitent de sortir la cathode de l'installation pour effectuer la transformation. Il faut donc, pour chaque opération, « casser » le vide, effectuer les opérations mécaniques de sortie de la cathode et de changement (rapide) de la cible, de réintroduction et surtout, de pompage pour restaurer le vide.

Une technique a été proposée pour raccourcir le temps nécessaire au démontage et au remontage de la plaque métallique constituant la cible. Au lieu d'une fixation périphérique par de nombreuses vis, il est prévu que ce soit le liquide de refroidissement lui-même, par l'intermédiaire d'une membrane souple qui appuie la plaque contre une cornière périphérique. Il suffit d'abaisser la pression du liquide pour libérer la plaque et pouvoir la remplacer par une autre.

Le document EP - A - 0 393 344 montre un tel dispositif. Il permet, comme on l'a vu, d'éviter d'avoir à dévisser et revisser de nombreux boulons lors du changement de cible. Malheureusement, il reste toujours nécessaire de sortir toute la cathode de la chambre, ce qui nécessite l'arrêt complet de l'installation pendant un temps très long. Par ailleurs, dans le cas des cathodes avec confinement du plasma grâce à des aimants, ceux-ci doivent forcément être situés derrière le réservoir de fluide de refroidissement, ce qui nuit à leur efficacité.

Dans le document US - A- 4 424 916, on présente une cathode rotative et l'on évoque la possibilité que le cylindre que constitue le matériau de la cible puisse être fait de plusieurs matériaux et qu'ainsi, « en tournant le tube, on puisse amener en positon de dépôt un matériau sélectionné ». Cette possibilité, simplement évoquée dans le document n'apporte pas de solution au problème de l'échauffement et de l'usure prématurée de la cible entre les endroits où les lignes de force du champ magnétique sortent et entrent dans le matériau de la cible.

La demande de brevet européen EP - A - 0 134 559 présente une cathode avec un support de cibles tubulaire sur lequel sont fixées des cibles planes, le tout formant un ensemble cylindrique dont la section est un polygone régulier. L'ensemble peut pivoter d'un angle défini autour de son axe de manière qu'une cible plane en remplace une autre, un nouveau matériau commençant alors à être pulvérisé à la place de l'ancien.

La variante préférée de l'invention précédente comporte un double système d'aimants, si bien que deux cibles sont utilisées simultanément.

Le système décrit dans le document EP - A - 0 134 559 qui permet un changement rapide du matériau à pulvériser, n'autorise ni une usure régulière de la cible, ni une puissance très élevée lorsque le matériau à pulvériser ne supporte pas les forts échauffements.

Le but de l'invention est de fournir une méthode rapide pour changer la cible d'une cathode de pulvérisation cathodique à magnétrons.

L'invention doit permettre également d'obtenir une consommation homogène du matériau de la cible pour éviter son usure rapide.

La technique de l'invention doit par ailleurs permettre de limiter l'échauffement de la cible afin d'autoriser l'accroissement de la puissance appliquée et donc des vitesses de dépôt accrues.

L'invention prévoit qu'une cathode rotative pour la pulvérisation cathodique comprenant un élément tubulaire pouvant tourner autour de son axe, support à sa périphérie d'au moins un matériau à pulvériser, ainsi qu'un système d'aimants et un dispositif de refroidissement, comporte des moyens mécaniques qui autorisent un mouvement de rotation oscillant de l'élément tubulaire pendant la pulvérisation.

De préférence, au moins deux matériaux à pulvériser ont une surface cylindrique dont l'axe est l'axe de rotation de l'élément tubulaire et qui est limitée par les génératrices constituant avec l'axe de rotation de l'élément tubulaire un dièdre d'ouverture α et l'angle d'oscillation de l'élément tubulaire pendant la pulvérisation est inférieur ou égal à α / 2. Ils sont avantageusement au nombre de deux et l'angle α a alors de préférence précisément la valeur 180 °.

La technique de l'invention permet non seulement un changement instantané de cible mais en plus, elle garantit une usure régulière du matériau à pulvériser sur pratiquement toute la surface de la cible et également, dans le cas de matériaux à bas point de fusion, elle autorise l'utilisation d'une puissance de dépôt supérieure.

Selon l'invention, il est également prévu que des écrans fixes soient placés de manière symétrique par rapport au plan bissecteur de l'angle d'oscillation de l'élément tubulaire avec un bord des écrans voisin de la surface cylindrique des matériaux à pulvériser et, de préférence, dans le cas de pulvérisation cathodique réactive, avec l'arrivée du gaz réactif entre les écrans fixes, du même côté de l'axe de rotation de l'élément tubulaire que le système d'aimants. Dans ce cas, les écrans sont à un potentiel électrique voisin de celui de la cathode et si une ou plusieurs anodes sont prévues, elles sont avantageusement placées entre les écrans.

Les différents dispositifs précédents sont destinés à favoriser un dépôt homogène et à éviter les décharges électriques qui pourraient être la cause de perturbations du procédé avec incidence possible sur la qualité du produit.

Les figures et la description suivantes permettront de comprendre le fonctionnement de l'invention et d'en apprécier les avantages.

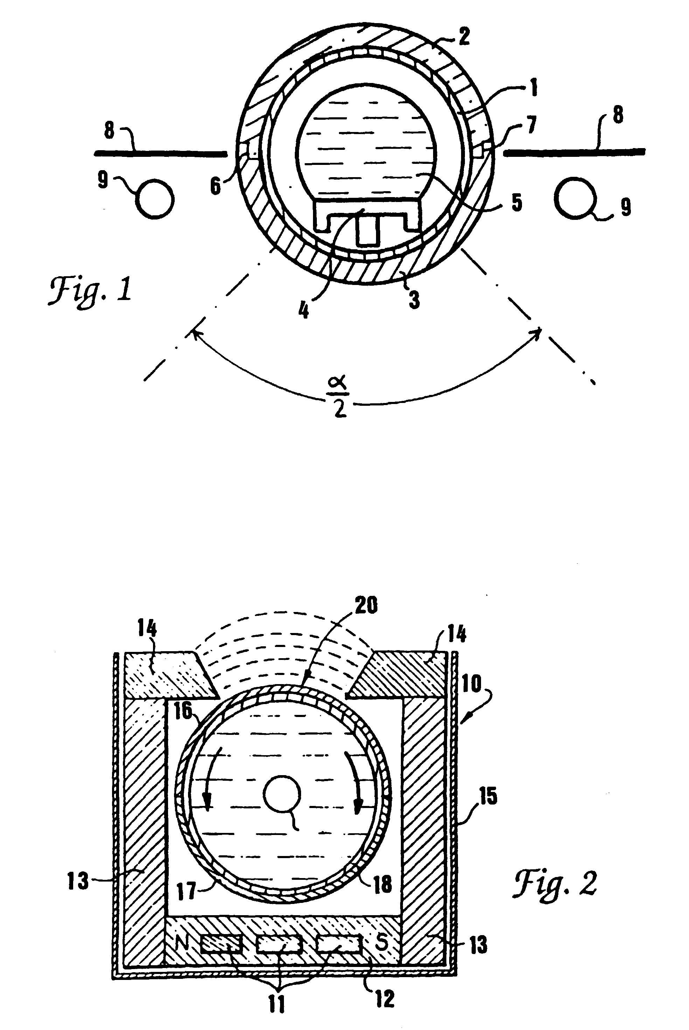

La figure 1 représente une cathode selon l'invention qui utilise le principe habituel de la cathode rotative et la figure 2 une variante où les aimants sont extérieurs au tube qui porte les cibles.

Sur la **figure 1**, on voit une coupe du dispositif de l'invention. Cette coupe est réalisée perpendiculairement à l'axe du cylindre de la cathode rotative animée classiquement par le mécanisme situé à l'une de ses extrémités. On voit sur la figure, en 1, l'élément tubulaire, support de la cible. Celle-ci, dans le cas de la figure, est en deux demi-cylindres 2 et 3 faits de matériaux différents. Il s'agit par exemple des deux métaux, silicium et titane dont l'empilement des oxydes va constituer un ensemble de couches anti-reflets comme celui de la demande de brevet français FR 93 - 14 793 qui prévoit qu'une cinquième couche en oxynitrure de silicium recouvre les quatre premières couches, alternativement en oxyde de titane TiO₂ et oxyde de silicium SiO₂.

A l'intérieur de l'élément tubulaire 1 qui est monté de telle manière qu'il puisse tourner autour de son axe, se trouve un système d'aimants 4 et un dispositif de refroidissement 5 qui, sur la figure, est associé au système d'aimants 4. Conformément à l'invention, l'élément tubulaire peut être animé d'un mouvement de rotation oscillant d'une amplitude d'angle α / 2 tel que α ≤ 180°.

α est, dans le cas général, l'angle du dièdre dont le sommet est l'axe du cylindre et dont les plans passent par les génératrices limitant une cible. En effet, les cibles sont identiques les unes aux autres. Sur la figure, la cible 2 et la cible 3 ayant une directrice hémicirculaire sont limitées par des droites directrices 6, 7 situées dans un même plan. α est donc égal à 180°.

Sur la figure, on a représenté également en 8 deux écrans qui s'écartent des cibles 2, 3 et dont un bord est voisin de la périphérie des cibles, c'est-à-dire de la surface cylindrique des matériaux à pulvériser. Ces écrans ont pour fonction de séparer les atmosphères de la cible en fonctionnement (3 sur la figure), des autres cibles. Cette disposition offre l'avantage, ou bien d'éviter la pollution de la cible inactive par l'atmosphère environnant la cible active (gaz réactif), ou bien de lui permettre de se régénérer si elle a été polluée lorsqu'elle était en activité.

Prenons l'exemple de l'empilement multicouches anti-reflets de la demande de brevet FR - 93 - 14793 dans laquelle alternent des couches de fort indice (TiO₂) et de faible indice SiO₂ et où l'une des cibles, la cible 3, est en titane tandis que l'autre 2 est en silicium. Lors du dépôt de la couche N°2, en silice SiO₂, le silicium a attiré de l'oxygène et la surface du métal a pu se recouvrir d'une couche d'oxyde isolant. Tant qu'elle reste mince, elle ne joue pas un rôle important mais si elle s'épaississait trop, elle gênerait le fonctionnement de la cathode qui ne pourrait plus attirer les ions argon. C'est pourquoi, pendant le dépôt de la couche suivante en oxyde de titane TiO₂, il est important qu'elle ne soit pas en présence de trop d'oxygène pour ne plus croître et reprendre rapidement son caractère métallique. Ce sont les écrans 8 qui permettent la séparation des atmosphères environnant les cibles 2 et 3.

Le fonctionnement qui vient d'être décrit est intéressant même si les cibles 2 et 3 sont faites du même matériau, alors pendant qu'une cible est active, l'autre peut se régénérer par bombardement ionique ou par effluvage si l'on introduit un autre gaz pour constituer l'effluve. On utilise alors alternativement une cible ou l'autre pour obtenir la même couche.

De manière à obtenir une usure uniforme des cibles, on fait osciller la cathode rotative pendant le dépôt avec une amplitude, on l'a vu, inférieure ou égale à α / 2. Le maximum α / 2 offre l'usure la plus régulière, mais l'autre cible pénètre dans la zone où la réaction peut se produire, ce qui peut présenter des inconvénients. Si ce phénomène est gênant, on se limite alors à des angles plus faibles.

Sur **la figure 1**, toujours, on a représenté les anodes qui sont de préférence à l'intérieur du dièdre d'ouverture α où se trouve la cible active. De même, c'est là également qu'on a placé la ou les arrivée(s) de gaz réactif non représentée(s).

Sur la **figure 2**, on a représenté un autre modèle de cathode 10, celui qui est décrit dans le brevet européen EP-B-0 461 035. Dans ce type de cathode rotative, le circuit magnétique 11, 12, 13, 14 est extérieur à la cathode. Il est contenu avec elle dans un carter 15. La cathode proprement dite comporte essentiellement comme élément tubulaire 20, l'ensemble des cibles, au nombre de deux sur la figure 16, 17, supporté par le tube 18. Le liquide de refroidissement est ici directement en contact avec lui, le circuit de retour du liquide est assuré par le tube 19. Comme pour les cathodes rotatives habituelles, la rotation est produite par un mécanisme situé à une extrémité, ici elle est réalisée par un moto-variateur à double sens de rotation.

Sur la figure 2, les cibles sont au nombre de deux, symétriques et l'oscillation de la cathode en rotation est de préférence de 90 °. Dans la configuration de la figure 2, la position des anodes est indifférente. De même, la position de l'arrivée de gaz réactif n'est pas déterminante puisque la géométrie de la cathode fait que la partie de cible non active est bien protégée à l'intérieur du circuit magnétique 12, 13, 14.

Les deux configurations qui viennent d'être décrites montrent deux matériaux de cible mais on ne sort pas du domaine de l'invention si l'on emploie un nombre différent, trois ou quatre par exemple. Avec trois, l'angle α est de 120 ° et la rotation limitée au maximum à 60 ° et avec quatre cibles, α serait de 90 ° et l'amplitude des oscillations inférieure ou égale à 45 °.

L'invention qui vient d'être décrite permet d'effectuer un changement de cible de manière pratiquement instantanée. Cela autorise la multiplication des couches minces qu'il est possible de déposer sur une ligne de production donnée sans avoir à ouvrir l'installation.

Par rapport à d'autres techniques, elle permet également d'avoir une usure régulière du matériau de la cible d'où un intérêt économique puisqu'on diminue les pertes et qu'on doit moins souvent procéder au changement de cible.

Le mouvement de va-et-vient de la cible permet également d'éviter les surchauffes locales et autorise donc, dans des conditions données, d'accroître la puissance et donc, la vitesse de dépôt.

## Revendications

1. Cathode rotative pour la pulvérisation cathodique comprenant un élément tubulaire pouvant tourner autour de son axe, support à sa périphérie d'au moins un matériau à pulvériser, ainsi qu'un système d'aimants et un dispositif de refroidissement, **caractérisée en ce qu'**elle comporte des moyens mécaniques qui autorisent un mouvement de rotation oscillant de l'élément tubulaire pendant la pulvérisation.

2. Cathode selon la revendication 1, **caractérisée en ce que** au moins deux matériaux à pulvériser ont une surface cylindrique dont l'axe est l'axe de rotation de l'élément tubulaire et qui est limitée par des génératrices constituant avec l'axe de rotation de l'élément tubulaire un dièdre d'ouverture α **et en ce que** l'angle d'oscillation de l'élément tubulaire pendant la pulvérisation est inférieur ou égal à α/2.

3. Cathode selon la revendication 2, **caractérisée en ce que** les matériaux à pulvériser sont au nombre de deux **et en ce que** l'angle α est de 180°.

4. Cathode selon l'une des revendications 2 ou 3, **caractérisée en ce que** des écrans fixes sont placés de manière symétrique par rapport au plan bissecteur de l'angle d'oscillation de l'élément tubulaire **et en ce qu'** un bord des écrans est voisin de la surface cylindrique des matériaux à pulvériser.

5. Cathode selon la revendication 4, **caractérisée en ce que** la pulvérisation cathodique est réactive **et en ce que** l'arrivée du gaz réactif s'effectue entre les écrans fixes du même côté de l'axe de rotation de l'élément tubulaire que le système d'aimants.

6. Cathode selon la revendication 4 ou la revendication 5, **caractérisée en ce que** les écrans sont à un potentiel électrique voisin de celui de la cathode.

7. Cathode selon l'une des revendications 4 à 6, **caractérisée en ce qu'**une ou plusieurs anodes sont placées entre les écrans.

## Patentansprüche

1. Drehkathode für die Kathodenzerstäubung, welche ein rohrförmiges Bauteil, das sich um seine Achse drehen kann und auf seinem Umfang mindestens ein zu zerstäubendes Material trägt, sowie ein Magnetsystem und eine Kühleinrichtung umfaßt, **dadurch gekennzeichnet, daß** sie mechanische Mittel enthält, die während der Zerstäubung eine schwingende Drehbewegung des rohrförmigen Bauteils ermöglichen.

2. Kathode nach Anspruch 1, **dadurch gekennzeichnet, daß** mindestens zwei zu zerstäubende Materialien eine zylindrische Oberfläche haben, deren Achse die Drehachse des rohrförmigen Bauteils ist und welche von Erzeugenden begrenzt wird, die mit der Drehachse des rohrförmigen Bauteils einen Raumöffnungswinkel α bilden, **und daß** während der Zerstäubung der Schwingungswinkel des rohrförmigen Bauteils kleiner oder gleich α/2 ist.

3. Kathode nach Anspruch 2, **dadurch gekennzeichnet, daß** zwei zu zerstäubende Materialien vorhanden sind und daß der Winkel α 180° beträgt.

4. Kathode nach Anspruch 2 oder 3, **dadurch gekennzeichnet, daß** in bezug auf die halbierende Ebene des Schwingungswinkels des rohrförmigen Bauteils feste Trennwände symmetrisch angeordnet sind **und daß** sich jeweils ein Rand der Trennwände nahe an der zylindrischen Oberfläche der zu zerstäubenden Materialien befindet.

5. Kathode nach Anspruch 4, **dadurch gekennzeichnet, daß** die Kathodenzerstäubung eine reaktive ist **und daß** die Zufuhr des Reaktionsgases zwischen den festen Trennwänden auf derselben Seite der Drehachse des rohrförmigen Bauteils wie der des Magnetsystems stattfindet.

6. Kathode nach Anspruch 4 oder 5, **dadurch gekennzeichnet, daß** an den Trennwänden ein elektrisches Potential anliegt, das etwa gleich dem der Kathode ist.

7. Kathode nach einem der Ansprüche 4 bis 6, **dadurch gekennzeichnet daß** zwischen den Trennwänden eine oder mehrere Anoden angeordnet sind.

## Claims

1. Rotary cathode for cathodic sputtering, comprising a tubular element capable of rotating about its axis, and acting as support at its periphery for at least one material to be sputtered, and also a system of magnets and a cooling device, characterized in that it comprises mechanical means which make possible an oscillating rotary movement of the tubular element during sputtering.

2. Cathode according to claim 1, characterized in that at least two materials to be sputtered have a cylindrical surface, the axis of which is the axis of rotation of the tubular element and which is bounded by generatrices making, with the axis of rotation of the tubular element, a dihedral angle α and in that the angle of oscillation of the tubular element during sputtering is less than or equal to α/2.

3. Cathode according to claim 2, characterized in that the materials to be sputtered are two in number and in that the angle α is 180°.

4. Cathode according to one of claims 2 or 3, characterized in that fixed screens are placed symmetrically about the bisector plane of the angle of oscillation of the tubular element and in that one edge of the screens is near the cylindrical surface of the materials to be sputtered.

5. Cathode according to claim 4, characterized in that the cathodic sputtering is reactive and in that the feed of the reactive gas takes place between the fixed screens on the same side of the axis of rotation of the tubular element as the system of magnets.

6. Cathode according to claim 4 or claim 5, characterized in that the screens are at an electrical potential close to that of the cathode.

7. Cathode according to one of claims 4 to 6, characterized in that one or more anodes are placed between the screens.
